# EUROPEAN PATENT APPLICATION

(11) **EP 4 786 895 A1**
(43) Date of publication of application: **05.08.2026**
(21) Application number: 25275005.4
(22) Date of filing: 31.01.2025
(51) Int. Cl.: F25D 19/00

(54) **THERMAL SWITCH, CRYOGENIC SYSTEM, AND MAGNETIC RESONANCE DEVICE**

(71) Applicant: Siemens Healthcare Limited, Camberley, Surrey GU15 3YL (GB)
(72) Inventor: Taylor, Owen, Appleton, OX13 5LQ (GB)
(74) Representative: Siemens Healthineers Patent Attorneys

(57) **Abstract**

The invention relates to a thermal switch (60) for a cryogenic system, comprising:
an inner part (61); an outer part (62); and a bung element (63); wherein the bung element (63) comprises a material with a higher thermal expansion coefficient than a material of the inner part (61), and wherein the bung element (63) is configured to bring the inner part (61) into contact with the outer part (62) when exceeding a predefined temperature level. The invention also relates to a cryogenic system (30) and a magnetic resonance device (10) comprising an inventive thermal switch (60).

## Description

Independent of the grammatical term usage, individuals with male, female or other gender identities are included within the term.

The current invention concerns a thermal switch for a cryogenic system and a magnetic resonance device.

Magnetic resonance imaging (MRI) is a widely used medical imaging technique that utilizes superconducting magnets to generate substantially homogenous magnetic fields. These superconducting magnets may require cooling to extremely low temperatures, typically around 4 Kelvin, to maintain their superconducting properties. Traditionally, MRI systems have used liquid helium baths to cool the superconducting magnets. However, recent advancements have led to the development of "cryogen-free" or "dry" MRI systems that do not require large liquid helium reservoirs.

In these dry MRI systems, cryocoolers are used to cool the superconducting magnets via thermal conduction. A typical cryocooler used in MRI applications is a two-stage pulse tube refrigerator, which can provide cooling at two temperature levels. For example, a first cooling stage of the two-stage pulse tube refrigerator may operate at around 40-60 Kelvin. The first cooling stage may be used to cool a thermal radiation shield which is configured to intercept radiative heat loads on the superconducting magnet. A second cooling stage of the two-stage pulse tube refrigerator may operate at around 4 Kelvin and be used to cool the superconducting magnet directly.

While "dry" MRI systems offer advantages in terms of reduced helium consumption and simplified maintenance, they can pose challenges with regard to cooling performance, particularly during an initial process of cooling down, but also after a ramp down of the superconducting magnet. The cooling powers of cryocoolers at very low temperatures are limited, typically to about 1 to 2 Watts at a temperature of 4 Kelvin for a standard two-stage refrigerator. This limited cooling power results in extended cooling times, which can take several days to weeks depending on the size and field strength of the superconducting magnet. In contrast, conventional MRI systems do not solely rely on the cryocooler, as they comprise a liquid cryogen bath or a cryogenic fluid system which can be pre-cooled via a stream of cold cryogen.

The extended cooling times associated with "dry" MRI systems present a significant drawback and can cause a delay of system commissioning as well as an increase in costs. In clinical settings, if a superconducting magnet must be ramped down, the prolonged recovery time leads to extended system downtime, impacting patient care and causing financial losses for healthcare providers.

Various approaches have been attempted to address the issue of extended cooling times in dry MRI systems. Some solutions involve using multiple cryocoolers (e. g. European patent application 24275099.0), which increases cooling power but also raises system complexity and operational costs. Others have explored the use of pre-cooling loops with liquid nitrogen or other cryogens, but this approach is often impractical at customer sites due to the lack of a dedicated cryogenic infrastructure.

It has been appreciated that a thermal management solution is needed that overcomes one or more of these problems.

Hence, it is an object of the present invention to provide a thermal management solution for cryogenic systems that enables rapid cooling of cryogenically cooled components while reducing system complexity and operational costs.

This object is achieved by a thermal switch, a cryogenic system and a magnetic resonance device according to the independent claims. Further advantageous embodiments are specified in the dependent claims.

The inventive thermal switch for a cryogenic system comprises an inner part, an outer part, and a bung element. The bung element comprises a material with a higher thermal expansion coefficient than a material of the inner part. The bung element is configured to bring the inner part into contact with the outer part when exceeding a predefined temperature level.

The thermal switch may be configured to control thermal conduction between two components in a cryogenic system. The thermal switch may comprise multiple parts that interact to enable and disable thermal conduction across the thermal switch in dependence of a temperature of one or more parts of the multiple parts. According to an embodiment, the thermal switch represents a passive thermal switch. For example, the thermal switch may be configured to enable and disable thermal conduction between two or more components without relying on an electrical, magnetic and/or optical control signal.

The inner part of the thermal switch may represent a thermally conductive element. For example, the inner part may comprise or consist of a material with high thermal conductivity, such as copper, aluminium, or other metals suitable for cryogenic applications.

The inner part and the outer part may have various shapes or geometries, such as a plate shape, a cylindrical shape, a prismatic shape, or any shape suitable for a specific cryogenic application. In an example, the inner part and the outer part comprise the shape of a ring structure, a hollow cylinder, or a hollow prism.

Similar to the inner part, the outer part of the thermal switch may represent a thermally conductive element. The outer part may be made of a similar material as the inner part. It is also conceivable, that the material of the outer part corresponds to the material of the inner part. The materials of the inner part and the outer part may be selected for their thermal conductivity and suitability for cryogenic temperatures. According to an embodiment, the outer part is shaped to accommodate the inner part. The outer part may also be shaped to allow for controlled contact between the outer part and the inner part. For example, the inner part and the outer part may be configured in such a way that a section of the inner part can be arranged within a section of the outer part.

The bung element may be configured as a temperature-sensitive component. For example, the bung element may comprise or consist of a material with a higher thermal expansion coefficient than the material of the inner part. Suitable materials for the bung element may include polymers such as polytetrafluoroethylene (PTFE), polyethylene, or other materials with a high thermal expansion coefficient relative to the material of the inner part.

The bung element may be configured to bring the inner part into contact with the outer part when exceeding a predefined temperature level. Particularly, the bung element may be configured to automatically enable thermal conduction between the inner part and the outer part when a temperature of the bung element rises above a certain threshold or predefined temperature level. The predefined temperature level may be defined by a geometry and/or a thermal property of one or more components (or parts) of the thermal switch, e. g. the inner part, the outer part, and the bung element. It is conceivable that the geometries and thermal properties of the components of the thermal switch are selected based on specific requirements of a cryogenic application and/or a cryogenic system comprising the thermal switch.

The thermal expansion properties of the bung element and the inner part may be selected in such a way to enable the thermal switch to function without the need for an external control mechanism. For example, the bung element may be configured to expand more than the inner part as the temperature increases, causing the inner part to deform and/or move into contact with the outer part. This contact may provide a thermal conduction path between the inner part and the outer part.

The thermal switch may provide several advantages in a cryogenic system. For example, the thermal switch may reduce or prevent parasitic heat loads by breaking a thermal contact between two components or devices connected via the thermal switch. Particularly, the thermal switch may prevent one or more components from being thermally connected to multiple cooling devices or cryocoolers configured to provide cooling at different temperature levels. This functionality may be beneficial during a cooling down of a cryogenic component, e. g. when multiple cryocoolers operate at different temperatures, but are initially operated together to increase the cooling capacity. Thus, the thermal switch may enable a more efficient use of cooling resources in cryogenic systems. Particularly, the thermal switch may reduce an overall energy consumption of a cryogenic system by enabling coolers which operate at higher temperatures to take part in pre-cooling or cooling down of cryogenic components.

According to an embodiment of the inventive thermal switch, at least a section of the bung element is arranged within a cavity of the inner part or a cavity formed by the inner part.

A section of the bung element may be circumferentially enclosed by a section of the inner part. For example, the bung element may be partially or fully inserted into a cavity or recess of the inner part. The cavity or recess in the inner part can be shaped to accommodate the bung element, allowing for a close fit between the two components. The bung element may be arranged within the inner part in such a way to improve or maximize a surface area of contact between the bung element and the inner part, potentially enhancing a mechanical engagement between these components when the temperature of the bung element exceeds the predefined temperature level.

The section of the bung element arranged within the inner part can vary in size and shape. For example, the section of the bung element can be a cylindrical protrusion that fits into a corresponding cylindrical cavity in the inner part. Alternatively, the section of the bung element can be a tapered or conical section that fits into a complementary shaped recess in the inner part.

In arranging a section of the bung element within a section of the inner part, the thermal expansion of the bung element can be more effectively translated into movement and/or deformation of the inner part. As the bung element expands with increasing temperature, it can exert pressure on a surrounding section or wall of the inner part. This pressure can cause the inner part to deform or expand outward, bringing the inner part into contact with the outer part of the thermal switch. Thus, an efficient thermal coupling between the bung element and the inner part, but also between the inner part and the outer part, may be provided. Furthermore, arranging a section of the bung element in a cavity of the inner part may favourably improve a transfer of a mechanical force provided by the thermal expansion of the bung element to the inner part, but also provide for a more controlled deformation of the inner part.

In having a section of the bung element arranged within the inner part, relative positions of these components can be maintained more reliably, potentially improving consistency and predictability of the thermal switch's operation across multiple thermal cycles. Thus, a mechanical stability and/or reliability of the thermal switch may favourably be improved.

An extent to which the bung element is inserted into the inner part can be adjusted or optimized based on factors such as the thermal expansion coefficients of the materials used, the desired activation temperature of the switch, and the mechanical properties of the components. Thus, the extent to which the bung element is inserted into the inner part may also allow for a fine-tuning of the switch's performance characteristics.

According to an embodiment of the inventive thermal switch, the bung element is configured to deform at least a section of the inner part when exceeding the predefined temperature level.

The bung element can be made of a material with a higher coefficient of thermal expansion than a material of the inner part. Thus, as the temperature increases, the bung element may expand more rapidly than the inner part. This differential thermal expansion can cause the bung element to exert pressure on the inner part, potentially leading to a deformation and/or compression of at least a section of the inner part.

The inner part can be configured to be elastically deformed and/or plastically deformed, depending on the materials used and the extent of the temperature change. Elastic deformation may allow the inner part to return to its original shape when the temperature drops below the predefined level. In contrast, plastic deformation may result in a permanent change to the shape of the inner part. In embodiments where the inner part is plastically deformed (e.g. due to the material choice for the inner part), an intermediate part according to an embodiment described below may be provided, which may be configured to revert a plastic deformation of the inner part, when the temperature of the intermediate part decreases below the predefined temperature level.

A bung element configured to deform the inner part when exceeding the predefined temperature level may favourably allow for a more reliable thermal connection and/or increased mechanical pressure between the inner part and the outer part. A deformation of the inner part can potentially increase the contact area between the inner part and the outer part, which may favourably reduce thermal resistance at an interfacial area between the inner part and the outer part and/or enhance thermal conductivity across the thermal switch. An increased contact area between the inner part and the outer part can result in more efficient heat transfer across the thermal switch when the thermal switch is in its thermally conductive state (e. g. when a temperature of the bung element exceeds the predefined temperature level).

Moreover, a bung element configured to deform the inner part by thermally expanding may favourably allow for a more gradual transition between a thermally conductive state and a thermally insulating state of the thermal switch. As the temperature of the bung element approaches the predefined level, the bung element may begin to deform the inner part slightly, potentially creating a partial thermal connection before full contact is achieved. This gradual transition can potentially reduce thermal shock and mechanical stress on one or more components of the thermal switch.

According to an embodiment of the inventive thermal switch, the inner part comprises a slot configured to facilitate a deformation of the inner part via the bung element.

The inner part may comprise one or more slots. A slot may represent an opening, a gap, or a recess in a structure or a wall of the inner part. The slot may be configured to allow for a controlled deformation or flexing of the inner part when subjected to forces exerted by the thermally expanding bung element. The one or more slots may be oriented in various directions, such as axially, radially, or circumferentially, depending on the desired deformation characteristics.

The one or more slots may comprise specific dimensions and/or arrangements to improve or optimize a deformation characteristic of the inner part. For example, a width, a depth, and/or a spacing of one or more slots may be selected to allow for sufficient flexibility while maintaining structural integrity of the inner part. The number and distribution of the one or more slots can be tailored to achieve uniform deformation across the inner part.

By incorporating one or more slots into the inner part, a deformation of the inner part by the thermally expanding bung element may be facilitated. This facilitated deformation can allow for improved thermal contact between the inner part and the outer part, potentially enhancing a switching performance of the thermal switch.

The presence of one or more slots in the inner part may provide several potential advantages. For example, the one or more slots can enable a more responsive thermal switching action, as the inner part can deform more easily in response to a mechanical force exerted by the thermal expansion of the bung element. This enhanced responsiveness may result in a faster activation and deactivation of the thermal switch. Moreover, the one or more slots may help reduce mechanical stress on the inner part during thermal cycling, potentially increasing longevity and reliability of the thermal switch.

According to an embodiment of the inventive thermal switch, the thermal switch further comprises an intermediate part arranged between the inner part and the outer part. The intermediate part comprises a material with a higher thermal expansion coefficient than the material of the inner part. The intermediate part is configured to separate the inner part from the outer part at a temperature below the predefined temperature level.

The intermediate part may be formed as a thin structure, e. g. a layer, a strip, or a tape, or a round cross-sectioned ring, positioned between the inner part and the outer part of the thermal switch. A shape and/or geometry of the intermediate part may be matched with a shape and/or geometry of the inner part, but also the outer part. For example, the intermediate part may be formed as a ring, a hollow cylinder, or a hollow prism. It is conceivable that the intermediate part is configured as a hollow cylinder or a thin cylindrical shell arranged in a dedicated slot or groove provided in an outer surface of the inner part and/or an inner surface of the outer part. If the inner part and the outer part comprise a prismatic shape, the intermediate part can also take the form of a hollow prism.

In providing a dedicated slot or groove in an outer surface of the inner part and/or an inner surface of the outer part, the intermediate part may favourably be prevented from slipping or moving relative to the inner part.

The intermediate part can be made from a material with a higher coefficient of thermal expansion compared to the material of the inner part. For example, if the inner part is made of copper or a different thermally conductive metal, the intermediate part can be made of a polymer material with a higher thermal expansion coefficient, such as polytetrafluoroethylene (PTFE) or any material suitable for the bung element mentioned above.

An intermediate part arranged between the inner part and the outer part may provide for an enhanced switching functionality of the thermal switch. At temperatures below the predefined temperature level, the intermediate part may compress or constrict the inner part due to its higher thermal expansion coefficient. For example, the temperature dependent thermal contraction of the intermediate part may cause the inner part to separate from the outer part, creating a gap between the inner part and the outer part. This separation can reduce or prevent thermal conduction between the inner part and the outer part when the temperature of the intermediate part is below the predefined temperature level.

The use of an intermediate part according to an embodiment described above may provide several potential advantages. For example, the intermediate part may favourably enhance thermal insulation capabilities of the thermal switch at lower temperatures, potentially improving an overall efficiency of a cryogenic system comprising the thermal switch. The intermediate part can also provide for a more gradual transition between the connected and disconnected states of the thermal switch, which may reduce mechanical stress on the components. Moreover, the intermediate part may potentially allow for finer tuning of a temperature at which the thermal switch activates or deactivates.

A material property of the intermediate part may be selected or designed to improve a separation between the inner part and the outer part at a specific temperature range, thus favourably allowing for a customization of the thermal switch for different cryogenic applications.

According to an embodiment of the inventive thermal switch, the predefined temperature level is at least 20 K, at least 30 K, at least 40 K, at least 50 K, at least 60 K, at least 70 K, at least 80 K, at least 90 K, or at least 100 K.

The predefined temperature level may refer to a temperature at and/or above which the bung element is configured to bring the inner part into contact with the outer part. The predefined temperature level can be selected based on the specific requirements of the cryogenic system in which the thermal switch is implemented.

A predefined temperature level of at least 40 K may allow for an effective thermal management in cryogenic systems for magnetic resonance devices. For example, in choosing materials and/or geometries of the inner part and/or the bung element in such a way that the predefined temperature level is between 40 K and 60 K, a cryocooler connected to a thermal radiation shield of a magnetic resonance device via the thermal switch may favourably be used to cool the thermal radiation shield down to an operating temperature of the thermal radiation shield, but not below.

In a similar fashion, a cryocooler connected to an arbitrary component of a magnetic resonance device via the thermal switch may favourably be used to cool the component down to an operating temperature of the cryocooler, and be thermally disconnected from the component via the thermal switch when the temperature of the component drops below the operating temperature of the cryocooler (for example, the component may be cooled by a further cryocooler operating at a lower temperature).

A thermal switch operating with a predefined temperature level of at least 40 K may provide several potential advantages. For example, the thermal switch may allow for efficient cooling of one or more components in a cryogenic system above 40 K while disabling active cooling (e. g. by disabling thermal conduction across the thermal switch) at temperatures below 40 K. The predefined temperature level may be matched with an operating temperature of a cooling stage of a cryocooler, enabling effective heat transfer when needed (e. g. during cooling down of a cryogenic system). Thus, multiple cryocoolers operating at different temperature levels may be used for cooling, allowing for individual cryocoolers to be thermally separated via one or more thermal switches when the lowest cooling temperature of a cryocooler and/or the predefined temperature level of a respective thermal switch is reached.

The specific value of the predefined temperature level can be selected based on factors such as the materials used in the components of the thermal switch, the geometries of the components of the thermal switch, the cooling requirements of the cryogenic system, and/or the operating temperatures of associated components. The predefined temperature level may be adjusted or optimized for different applications or system configurations.

According to an embodiment of the inventive thermal switch, the inner part is thermally and mechanically connected to a solid thermal conductor.

The solid thermal conductor may comprise or consist of a material with high thermal conductivity, such as copper, aluminium, or a metal alloy. The solid thermal conductor can be configured to efficiently transfer heat between the inner part of the thermal switch and another component of the cryogenic system, such as a component of a magnet arrangement of a magnetic resonance device.

According to an embodiment, the inner part is thermally and mechanically connected to the solid thermal conductor in such a way to allow for thermal conduction between the inner part and the solid thermal conductor. For example, a thermal connection between the inner part and the solid thermal conductor can be achieved through direct physical contact between the inner part and the solid thermal conductor, but also via a thermally conductive interface material, such as a thermally conductive adhesive, a weld joint, or a solder joint. It is conceivable that the inner part is mechanically and thermally connected to the solid thermal conductor via a form-fitting connection, a force-fitting connecting and/or a material bond. For example, the inner part may be screwed, bolted, clamped, glued and/or soldered to the solid thermal conductor.

A mechanical connection between the inner part and the solid thermal conductor may improve structural support and allow maintenance of spatial positionings of the components of the thermal switch. Furthermore, the solid thermal conductor may favourably provide a thermal connection to other components of the cryogenic system or parts to be cooled.

An inner part thermally and mechanically connected to a solid thermal conductor may provide a robust and efficient heat conduction path between the inner part of the thermal switch and a component connected to the solid thermal conductor when the thermal switch is in its thermally conductive state.

Furthermore, a solid thermal conductor thermally and mechanically connected to the inner part may favourably enable a flexible positioning of the thermal switch relative to the component to be cooled, as the solid thermal conductor can bridge any physical gap between these elements. Moreover, the solid thermal conductor may act as a thermal buffer, helping to smooth out temperature fluctuations and provide more stable cooling performance.

According to an embodiment of the inventive thermal switch, the inner part and the outer part comprise the shape of a ring, a hollow cylinder, or a hollow prism.

A hollow cylinder or a ring-shaped structure may favourably allow for a compact or space-saving design of the thermal switch. For example, a ring or hollow cylinder shape can provide a large surface area for thermal contact between the inner part and the outer part when they are brought into contact by the bung element.

According to an embodiment, the inner part and the outer part are arranged as concentric rings or concentric hollow cylinders. For example, a longitudinal axis or cylinder axis of the inner part may coincide with a longitudinal axis or cylinder axis of the outer part. It is also conceivable that the bung element comprises a cylindrical body. A longitudinal axis or cylinder axis defined by the cylindrical body of the bung element may coincide with the longitudinal axis or cylinder axis defined by the inner part and/or the outer part.

A thermal switch comprising concentrically arranged components may favourably allow for a substantially uniform mechanical engagement between the bung element and the inner part, but also between the inner part and the outer part, ensuring a consistent and/or uniform thermal contact or separation between the inner part and the outer part.

An inner part and an outer part comprising the shape of a ring or hollow cylinder may also facilitate an assembly and disassembly of the thermal switch. For example, the inner part and the outer part may be configured to fit together in a compact and/or nested configuration, saving space, but also simplifying manufacturing and maintenance processes.

According to a further embodiment, the inner part and the outer part comprise the shape of a hollow prism. The shape of a hollow prism can offer similar advantages as shapes based on rings or hollow cylinders, while potentially allowing for different mounting and/or integration options in a cryogenic system.

The choice between a ring shape, a hollow cylinder shape, or a hollow prism shape for the inner part and the outer part can depend on various factors such as the specific design requirements of the cryogenic system, manufacturing considerations, but also desired thermal performance characteristics of the thermal switch. In each case, a shape of a section of the bung element may correspond or conform to a shape of a section of the inner part.

According to an embodiment of the inventive thermal switch, the outer part is thermally and mechanically connected to a cryocooler or other cooling device.

The cryocooler can be a device configured to provide cooling to components of a cryogenic system. As used herein, the term "cryocooler" may refer to a refrigeration device capable of reaching cryogenic temperatures, typically below 120 K. A cryocooler may be classified based on its lowest achievable temperature, such as a high-temperature cryocooler operating between 50 K and 120 K, a low-temperature cryocooler operating between 20 K and 50 K, or an ultra-low temperature cryocooler operating below 20 K. In some cases, cryocoolers may be further categorized by their specific temperature ranges, for example, 4 K cryocoolers for applications requiring temperatures near liquid helium, or 77 K cryocoolers for applications near liquid nitrogen temperatures.

The term other cooling device may refer to a cold finger or cold head of a cryocooler, but also a variable temperature gas flow insert, a pre-cooling line through which a cryogen is passed, or any other passive or active device configured to cool a component in a cryogenic system.

The thermal and mechanical connection between the outer part and the cryocooler may be configured to allow for an efficient heat transfer between the outer part and the cryocooler. According to an embodiment, the outer part may be connected to the cryocooler via a force-locking connection, a form-locking connection and/or a material bond. For example, the outer part may be screwed, bolted, clamped, glued, soldered and/or welded to the cryocooler. It is also conceivable that the outer part is thermally connected to the cryocooler using a thermal interface material with a high thermal conductivity (e. g. an indium layer or indium foil).

The outer part may be thermally and mechanically connected to a cooling stage of the cryocooler. It is also conceivable that the outer part is thermally and mechanically connected to a heat exchanger attached to the cooling stage of the cryocooler. The heat exchanger may be a component configured to transfer heat between the thermal switch and the cryocooler via thermal conduction.

The mechanical and thermal connection between the outer part and the cryocooler may allow for efficient cooling of one or more components connected to the thermal switch. Particularly, the thermal and mechanical connection between the outer part and the cryocooler may allow for a precise temperature control of the thermal switch, which may be crucial for an operation in cryogenic systems.

Moreover, a thermal and mechanical connection between the outer part and the cryocooler may allow for a rapid cooling of the thermal switch when needed, potentially improving an overall efficiency of the cryogenic system.

According to an embodiment of the inventive thermal switch, the bung element comprises or consists of a plastic material, preferably polytetrafluoroethylene.

The bung element can be made from a plastic material. Plastic materials may be selected for their thermal expansion properties or high thermal expansion coefficients, which can be advantageous for the operation of the thermal switch. The thermal expansion coefficient of a plastic material may exceed the thermal expansion coefficient of a metal used for the inner part, but also the outer part, allowing for greater dimensional changes with temperature variations. An increased thermal expansion coefficient may enable the bung element to effectively bring the inner part into contact with the outer part when exceeding the predefined temperature level.

Polytetrafluoroethylene (PTFE) may represent a suitable material for the bung element. PTFE may be selected for its high coefficient of thermal expansion, low friction properties, and/or chemical inertness. A bung element made from PTFE may favourably allow for a reliable and repeatable operation of the thermal switch over multiple thermal cycles.

In some embodiments, however, other plastic materials can be used for the bung element. For example, high-density polyethylene (HDPE) or polyoxymethylene (POM) may be suitable alternatives. These materials may also exhibit high coefficients of thermal expansion, which enable the bung element to effectively bring the inner part into contact with the outer part when exceeding the predefined temperature level.

The use of plastic materials for the bung element can provide several potential advantages. For example, plastic materials can be lightweight, which may reduce the overall mass of the thermal switch. Furthermore, plastic materials can be easily machined and/or moulded to precise dimensions, allowing for an accurate control of an activation temperature of the thermal switch (e. g. the predefined temperature level). The low thermal conductivity of plastic materials can also help to minimize unwanted heat transfer when the thermal switch is in an open or nonconductive state.

Moreover, the choice of material for the bung element may favourably allow for a customization of the thermal switch's performance. Different plastic materials may exhibit varying coefficients of thermal expansion, enabling the thermal switch to be tailored for specific temperature ranges or applications within the cryogenic system.

The inventive cryogenic system comprises a cryocooler, a part to be cooled, and a thermal switch according to an embodiment described above. The outer part is thermally and mechanically connected to the cryocooler. The inner part is thermally and mechanically connected to the part to be cooled. The thermal switch is configured to enable thermal conduction between the part to be cooled and the cryocooler when a temperature of the bung element exceeds the predefined temperature level.

According to an embodiment of the cryogenic system, the cryocooler is configured to provide cooling at a cryogenic temperature. The cryocooler may utilize various thermodynamic cycles, such as the Gifford-McMahon cycle, the pulse tube cycle, or the Stirling cycle, to achieve cryogenic temperatures. The cryocooler may comprise one or more cooling stages. In case the cryocooler comprises multiple cooling stages, each cooling stage may be configured to provide cooling at a different temperature level.

The part to be cooled may represent any component or structure that requires cooling to cryogenic temperatures. For example, the part to be cooled may comprise, but is not limited to, a superconducting magnet, a support structure for a superconducting magnet, a thermal radiation shield, and/or a cryogen vessel.

The thermal switch may be configured to control thermal conduction between the cryocooler and the part to be cooled. Particularly, the thermal switch may be configured to enable and disable thermal conduction between the cryocooler and the part to be cooled in dependence of the temperature of the bung element. Thus, the thermal switch may allow for efficient and controlled cooling of the part to be cooled.

The outer part of the thermal switch may be thermally and mechanically connected to the cryocooler. The thermal and mechanical connection between the outer part and the cryocooler may be achieved according to an embodiment described above. For example, the outer part may be bolted, screwed, soldered, brazed, and/or clamped to the cryocooler.

The inner part of the thermal switch can be thermally and mechanically connected to the part to be cooled. The thermal and mechanical connection between the inner part and the part to be cooled may be achieved in accordance with an embodiment described above. According to an embodiment, the inner part may be thermally and mechanically connected to the part to be cooled via a solid thermal conductor.

A cryogenic system comprising an inventive thermal switch can provide several potential advantages. For example, the cryogenic system may allow for an efficient and controlled cooling of cryogenic components. The thermal switch may enable the use of additional cooling power or additional cryocoolers when needed, potentially reducing cooling times. The cryogenic system may also allow for thermal separation of components and/or cryocoolers when the additional cooling power is not required, potentially improving overall system efficiency. The cryogenic system shares the advantages of the thermal switch according to an embodiment described above.

According to an embodiment of the inventive cryogenic system, the part to be cooled comprises at least one of: a thermal radiation shield, a further thermal radiation shield, a superconducting magnet, a support structure for a superconducting magnet.

The part to be cooled can be any component within the cryogenic system that requires cooling.

A thermal radiation shield can be a structure configured to reduce radiative heat transfer between different temperature regions in the cryogenic system. For example, the thermal radiation may be configured to reduce or prevent a transfer of heat energy between an outer enclosure and a cold mass of the cryogenic system. Particularly, the thermal radiation shield may be configured to reduce a transfer of heat energy between a wall of an outer vacuum chamber and a superconducting magnet of the cryogenic system, The thermal radiation shield may comprise or consist of a material with low emissivity, such as a polished metal, to reflect thermal radiation.

A further thermal radiation shield may represent an additional shield layer, which may be used to provide enhanced thermal insulation. Multiple thermal radiation shields can be employed in a nested configuration to progressively reduce heat transfer from warmer to colder regions of the cryogenic system.

A superconducting magnet may comprise one or more superconducting coils made from superconducting wire or tape. The superconducting magnet may be configured to generate a substantially homogeneous magnetic field in a predefined spatial position relative to the superconducting magnet. The superconducting magnet may be mechanically connected to a support structure configured to provide mechanical support to the superconducting magnet. Typically, superconducting magnets need to be cooled below a critical temperature or superconducting temperature in order to minimize resistive losses. Superconducting magnets can be used in various applications, including magnetic resonance imaging (MRI) systems, particle accelerators, and nuclear magnetic resonance (NMR) spectroscopy.

A support structure for a superconducting magnet may represent a mechanical framework designed to hold and/or position the superconducting magnet within the cryogenic system. The support structure can be engineered to minimize heat conduction from warmer regions to the superconducting magnet while providing necessary mechanical stability to withstand electromagnetic forces of the superconducting magnet. It is conceivable that the support structure is configured to thermally connect the superconducting magnet to a cryocooler and/or a thermal switch according to an embodiment described above. For example, the support structure may be mechanically and thermally connected to a solid thermal conductor according to an embodiment described above. According to an embodiment, the solid thermal conductor may form a part of the support structure.

The inventive thermal switch may favourably allow for efficient and/or rapid cooling of the cryogenic system by enabling thermal conduction between one or more parts to be cooled and the cryocooler when the temperature of the bung element exceeds the predefined temperature level.

A cryogenic system according to the invention may favourably allow for multiple cryocoolers to be thermally connected to one or more parts to be cooled via one or more thermal switches, which may allow for a rapid initial cooling of the one or more parts to be cooled, potentially reducing the time required to bring the cryogenic system to its operating temperature.

Moreover, the ability to selectively cool different components via the thermal switch may favourably allow for an optimized thermal management within the cryogenic system. For example, the thermal radiation shield can be cooled rapidly during an initial process of cooling down via a second or dedicated cryocooler, which may help to reduce an overall heat load on the superconducting magnet.

Furthermore, a cryocooler operating at a higher temperature than the operating temperature of a part to be cooled may be thermally connected to the part to be cooled via the thermal switch during a process of cooling down. Cryocoolers operating at higher temperatures typically offer higher cooling capacities, but also higher coefficients of performance, favourably reducing an overall cooling time of the part to be cooled, but also operating costs of the cryogenic system.

According to an embodiment of the cryogenic system, the cryocooler comprises a single-stage cryocooler.

A single-stage cryocooler may represent a type of cryocooler that utilizes a single cooling stage to achieve cryogenic temperatures. In contrast to multi-stage cryocoolers, which may employ multiple cooling stages in series to reach progressively lower temperatures, a single-stage cryocooler may achieve the desired low temperature in one step or stage.

The single-stage cryocooler may be configured to provide cooling at a predetermined temperature level. This predetermined temperature level may be selected based on the specific cooling requirements of the part to be cooled in the cryogenic system. For example, the single-stage cryocooler can be designed to operate at a temperature range suitable for cooling a thermal radiation shield or other components that do not require cooling to extremely low temperatures (such as the superconducting temperature of a superconducting magnet).

It is also conceivable that the single-stage cryocooler is thermally connected to a superconducting magnet via a thermal switch according to the invention. The single-stage cryocooler may not be capable to provide cooling at a temperature level required for the operation of the superconducting magnet. However, the single-stage cryocooler may still be used to speed up the process of cooling down of the superconducting magnet. For example, the single-stage cryocooler may be thermally disconnected from the superconducting magnet via the thermal switch, once the lowest temperature level of the single-stage cryocooler has been reached and/or a temperature of the bung element drops below the predefined temperature level.

Various types of single-stage cryocoolers can be used in the inventive cryogenic system. These may include, but are not limited to, Gifford-McMahon (GM) cryocoolers, pulse tube cryocoolers, or Stirling cryocoolers.

A combination of a thermal switch according to the invention and a single-stage cryocooler may provide several potential advantages. For example, the thermal switch may be configured to thermally disconnect the single-stage cryocooler from the part to be cooled, once the part to be cooled is at a temperature close to or below the lowest temperature provided by the single-stage cryocooler. Thus, the single-stage cryocooler may favourably be used in conjunction with at least one other cryocoolers configured to provide the temperature level required for the cryogenic application, which allows for a reduced cooling time. Furthermore, cryocoolers operating at higher temperature levels may offer higher coefficients of performance, reducing a total amount of energy required for pre-cooling or cooling down the part to be cooled and increasing an overall efficiency of the cryogenic system.

According to an embodiment, the cryogenic system comprises a solid thermal conductor arranged between the thermal switch and the part to be cooled.

The thermal conductor may be thermally arranged between the thermal switch and the part to be cooled. For example, the solid thermal conductor may be thermally and mechanically connected to both the thermal switch and the part to be cooled. Various connection methods can be used, such as bolting, clamping, brazing, glueing and/or soldering, to ensure good thermal contact and mechanical stability. The solid thermal conductor may be configured in accordance with an embodiment described above. For example, the solid thermal conductor may comprise or consist of a material with high thermal conductivity, such as copper, aluminium, or a metal alloy.

A solid thermal conductor arranged between the thermal switch and the part to be cooled may provide several potential advantages. For example, the solid thermal conductor can help distribute heat energy more evenly across a surface of the part to be cooled and/or the inner part, potentially improving cooling efficiency. Furthermore, the solid thermal conductor may act as a thermal buffer, helping to smooth out temperature fluctuations and provide more stable cooling.

In some embodiments, the solid thermal conductor can be shaped to fit a specific geometry of the thermal switch and/or a specific geometry of the part to be cooled. For example, the solid thermal conductor may comprise a flat plate, a curved surface and/or a complex three-dimensional shape, depending on the requirements of the cryogenic system.

A solid thermal conductor may favourably allow for improved flexibility in the design and placement of the thermal switch relative to the part to be cooled. This can be particularly advantageous in complex cryogenic systems where space constraints or other design considerations may limit the direct placement of the thermal switch.

The inventive magnetic resonance device is configured to acquire magnetic resonance data from an object positioned in an imaging region of the magnetic resonance device.

Preferably, the magnetic resonance device is configured to acquire magnetic resonance image data, particularly diagnostic magnetic resonance image data, from the object positioned within the imaging region. The object may be an inanimate object or a patient, particularly a human or an animal.

The inventive magnetic resonance device may represent a closed bore scanner. A closed bore scanner may comprise a substantially cylindrical bore circumferentially enclosing the imaging region. The magnet arrangement of the closed bore scanner may comprise a superconducting magnet including one or more solenoidal superconducting magnet coils (or solenoidal superconducting magnets) circumferentially encompassing the imaging region along an axial direction or an axis of rotational symmetry of the cylindrical bore. The one or more superconducting magnet coils may comprise a superconducting wire having a negligible electrical resistance at (or below) a superconducting temperature. A direction of a main magnetic field provided by the one or more superconducting magnet coils may be oriented substantially in parallel to a direction of access of the object to the imaging region and/or the axial direction of the cylindrical bore.

In other embodiments, the inventive magnetic resonance device may be configured as an open bore scanner, a C-type scanner, a single-sided scanner, or the like.

The inventive magnetic resonance device may represent a "dry" MRI system comprising a minimum of cryogen or no cryogen at all. For example, the magnetic resonance device comprises one or more small cryogen vessels thermally connected to the superconducting magnet via a solid thermal conductor. The one or more small cryogen vessels may contain a volume of less than 10 l, less than 5 l, or less than 1 l of cryogen. According to an embodiment of the magnetic resonance device, a cryogen vessel is omitted, and the magnet arrangement is cooled entirely via thermal conduction. A dry MRI system can also be characterized by the fact that the superconducting magnet is not directly immersed in a cryogen. Preferably, the superconducting magnet of a dry MRI system is connected to the cryocooler by means of a solid thermal conductor according to an embodiment described herein.

The magnetic resonance device comprises a magnet arrangement including a superconducting magnet and a cryogenic system according to an embodiment described above. The thermal switch is configured to enable a thermal conduction between a component of the magnet arrangement and the cryocooler when a temperature of the bung element exceeds the predefined temperature level.

The inventive magnetic resonance device may comprise further components required for a proper operation of the magnetic resonance device. For example, the magnetic resonance device may comprise an outer vacuum chamber, a magnet support structure, one or more thermal radiation shields, a shield tube and/or a magnet arrangement according to an embodiment described herein. In certain embodiments, the magnetic resonance device and/or the magnet arrangement comprise a cryogen vessel. A component of the magnet arrangement thermally connected to the cryocooler via the thermal switch can be at least one of: a thermal radiation shield, a further thermal radiation shield, the superconducting magnet, a support structure for the superconducting magnet.

A cryogen vessel may be configured for storing or preserving a fluid, particularly a cryogen, at a desired temperature level. Preferably, the fluid or cryogen exhibits a low boiling point. Examples of suitable fluids or cryogens are argon, nitrogen, neon, helium, or the like. The desired temperature level may substantially correspond to a superconducting temperature of the at least one superconducting magnet.

The superconducting magnet may be configured to generate a substantially homogenous magnetic field suitable for magnetic resonance imaging applications. The superconducting magnet may include one or more superconducting coils made of a superconducting material, such as niobium-titanium or niobium-tin. Superconducting materials need to be maintained at a temperature below a critical temperature or superconducting temperature to achieve superconductivity. The superconducting coils may consist of low temperature superconducting materials or high temperature superconducting materials.

The cryogenic system may be configured to maintain the superconducting magnet at a temperature below the critical temperature or superconducting temperature. The cryogenic system can include one or more cryocoolers and a thermal switch according to an embodiment described above.

The thermal switch may be configured to enable thermal conduction between a component of the magnet arrangement and the cryocooler when a temperature of the bung element exceeds the predefined temperature level. The thermal switch may favourably allow for efficient cooling of one or more components of the magnet arrangement during an initial process of cooling down, after a quench event, but also after an intended or unintended ramp down of the superconducting magnet. It is also conceivable that the thermal switch is configured to thermally separate the one or more components of the magnet arrangement from a cryocooler when a desired or predefined temperature is reached.

The use of an inventive thermal switch in the magnetic resonance device can provide several potential advantages. For example, the thermal switch can provide an automated thermal separation between a component of the magnetic resonance device and a cryocooler connected to the thermal switch when the desired operating temperature of the component of the magnet arrangement and/or the lowest operating temperature of the cryocooler is reached. This can improve the energy efficiency of the magnetic resonance device. Furthermore, the use of an inventive thermal switch may allow for multiple cryocoolers to be used, which can significantly reduce the cooling time of the component of the magnet arrangement. Once the bung element reaches the predefined temperature level, one or more cryocoolers may be thermally separated from the one or more components of the magnet arrangement, which may reduce the energy consumption of cooling infrastructure of the magnetic resonance device.

An inventive magnetic resonance device may provide improved reliability and performance in clinical and research settings. The inventive magnetic resonance device shares the advantages of the inventive cryogenic system and the inventive thermal switch.

Embodiments of the invention are illustrated in the drawings and will be described in more detail below. The same reference signs are used for the same features in different figures. The figures show:
- Fig. 1: shows a magnetic resonance device according to an embodiment of the invention.
- Fig. 2: illustrates a schematic representation of a thermal switch according to an embodiment of the invention.
- Fig. 3: illustrates a perspective view of an inner part of a thermal switch according to an embodiment of the invention.
- Fig. 4: shows a schematic representation of a section of a magnetic resonance device comprising a cryogenic system according to an embodiment of the invention.
- Fig. 5: illustrates a schematic representation of a thermal switch according to an embodiment of the invention.

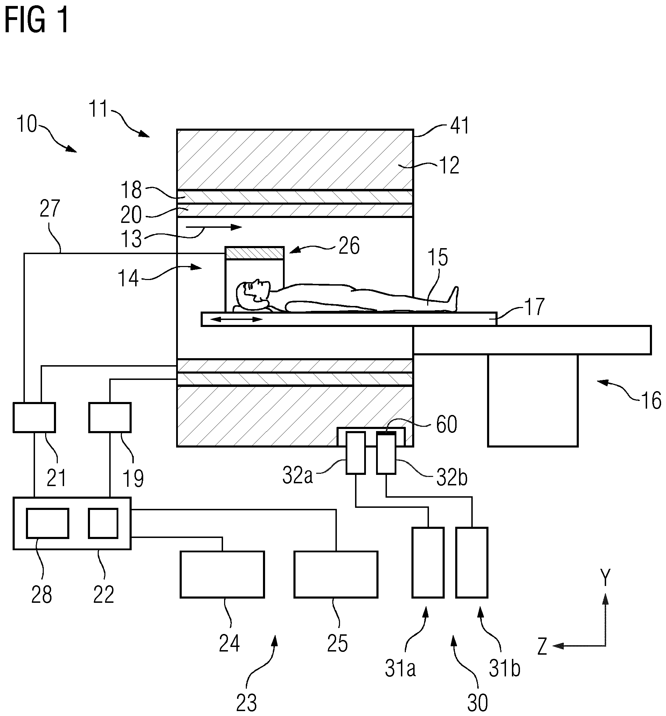

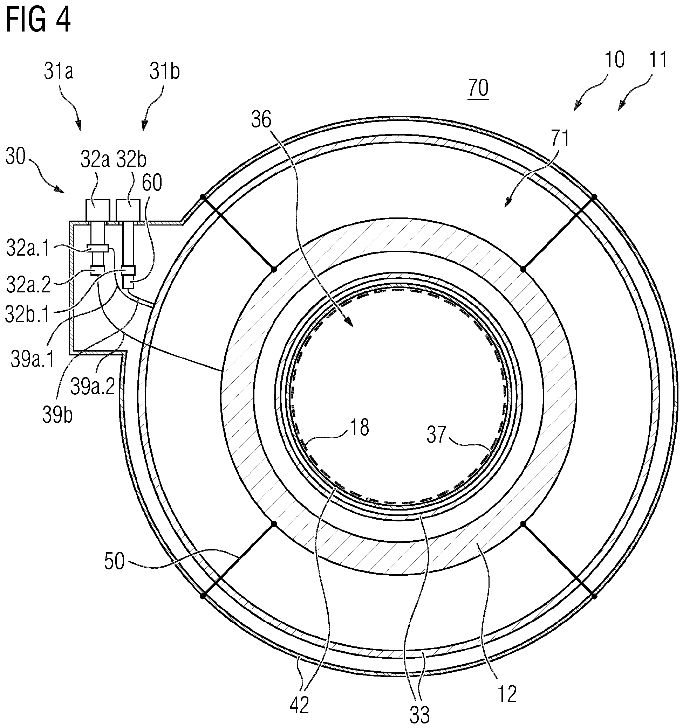

Fig. 1 shows an embodiment of a magnetic resonance device 10 according to the invention. The magnetic resonance device 10 comprises a static field magnet or main magnet 12 including one or more superconducting magnets (not shown) configured to provide a homogenous, static magnetic field 13 (B0 field). The static magnetic field 13 permeates an imaging region 14 configured to receive an imaging object, such as a patient 15. The imaging region 14 may correspond to an inner volume of a patient bore 37 (see Fig. 4) configured to accommodate a patient 15 during a magnetic resonance measurement. In the depicted embodiment, the imaging region 14 is encompassed by the main magnet 12 in a circumferential direction. The main magnet 12 may form a part of a magnet arrangement 11.

The magnetic resonance device 10 may comprise a patient positioning device 16 configured to transport the patient 15 into the imaging region 14. Particularly, the patient positioning device 16 may be configured to transport a diagnostically relevant body region of the patient 15 into an imaging volume or isocentre (not shown) of the magnetic resonance device 10. The magnet arrangement 11 and other components of the magnetic resonance device 10 may be concealed in a housing 41.

The magnetic resonance device 10 may comprise a gradient system including one or more gradient coils 18. The one or more gradient coils 18 may be configured to generate gradient magnetic fields in different, preferably orthogonally oriented, spatial directions. The gradient magnetic fields can be used for spatial encoding of magnetic resonance signals or magnetic resonance data acquired during a magnetic resonance measurement. The one or more gradient coils 18 can be activated or controlled via an appropriate control signal provided by a gradient control unit 19.

The magnetic resonance device 10 may further comprise an integrated radiofrequency antenna 20 (i. e. a body coil). The radiofrequency antenna 20 may be activated or controlled via a radiofrequency control unit 21. The radiofrequency control unit 21 may be configured to control the radiofrequency antenna 20 to generate a high frequency magnetic field and emit radiofrequency excitation pulses into the imaging region 14.

The magnetic resonance device 10 may further comprise a local coil 26. The local coil 26 may be positioned on or in proximity to a diagnostically relevant body region of the patient 15. The local coil 26 may be configured to emit radiofrequency excitation pulses into the patient 15 and/or receive magnetic resonance signals from the patient 15. It is conceivable, that the local coil 26 is controlled via the radiofrequency controller 21.

Preferably, the magnetic resonance device 10 comprises a control unit 22 configured to control the magnetic resonance device 10. The control unit 22 may comprise a processing unit 28 configured to process magnetic resonance signals and reconstruct magnetic resonance images from acquired magnetic resonance signals. The processing unit 28 may also be configured to process input from a user of the magnetic resonance device 10 and/or provide an output to a user. For this purpose, the processing unit 28 and/or the control unit 22 can be connected to a display unit 24 and an input unit 25 via a suitable signal connection. For a preparation of a magnetic resonance measurement, preparatory information, such as imaging parameters or patient information, can be provided to the user via the display unit 24. The input unit 25 may be configured to receive information and/or imaging parameters from the user. The display unit 24 and the input unit 25 may form a part of a user interface 23 configured to enable the user to interact with the magnetic resonance device 10.

In the example depicted in Fig. 1, the magnetic resonance device 10 comprises two cryocoolers 31a and 31b configured to cool the main magnet 12, but also other components of the magnet arrangement 11. The cryocoolers 31a and 31b may each comprise one or more compressors (not shown) supplying pressurized gas or cryogen to the cryocoolers 31a and 31b. However, it is also conceivable that the cryocoolers 31a and 31b share a single compressor.

Each cryocooler 31a, 31b may include a cold head 32a, 32b comprising one or more cooling stages (not shown). According to an embodiment, a second stage of the cold head 32a of the first cryocooler 31a is thermally connected to the main magnet 12, while a first stage of the cold head 32a of the first cryocooler 31a is thermally connected to other components of the magnet arrangement 11, such as a thermal radiation shield 33, a further thermal radiation shield, a shield tube, a buffer unit, or the like (see Fig. 4).

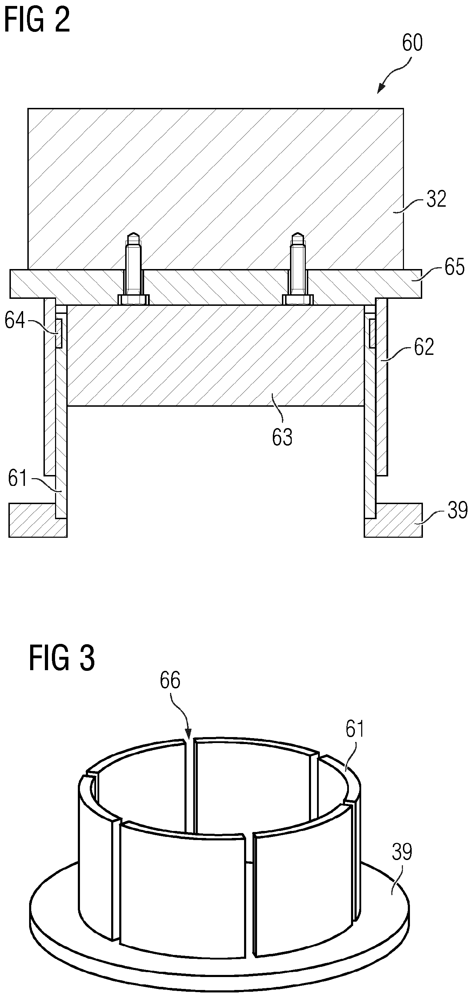

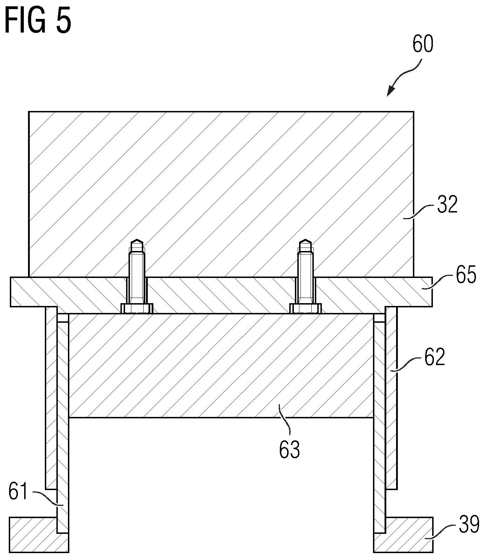

The second cryocooler 31b may include a cold head 32b comprising a single cooling stage. The second cryocooler 31b may be thermally connected to a component of the magnet arrangement 11 via a thermal switch 60. The thermal switch 60 may be configured to enable thermal conduction between the component of the magnet arrangement 11 and the second cryocooler 31b when a temperature of a bung element 63 (see Fig. 2 and Fig. 5) of the thermal switch 60 exceeds a predefined temperature level.

Of course, the magnetic resonance device 10 may comprise further components and/or functions which are common in magnetic resonance devices. The general operation of a magnetic resonance device 10 is known to those skilled in the art, so a more detailed description is omitted.

Fig. 2 depicts a schematic representation of an embodiment of an inventive thermal switch 60 for a cryogenic system 30. In the illustrated example, the thermal switch 60 comprises an inner part 61, an outer part 62, and a bung element 63. The bung element 63 comprises a material with a higher thermal expansion coefficient than a material of the inner part 61. The bung element 61 is configured to bring the inner part 61 into contact with the outer part 62 when exceeding a predefined temperature level.

The thermal switch 60 may be configured to provide a thermally conductive connection between a cold head 32 of a cryocooler 31 and a solid thermal conductor 39 as shown in Fig. 2. Particularly, the outer part 62 of the thermal switch 60 may be thermally and mechanically connected to the cold head 32, and the inner part 61 of the thermal switch 60 may be thermally and mechanically connected to the solid thermal conductor 39. The solid thermal conductor 39 may be thermally and mechanically connected to a part to be cooled, e. g. a component of the magnet arrangement 11 (see Fig. 4).

The cold head 32 may comprise a heat exchanger 65, e. g. a plate heat exchanger as depicted in the example illustrated in Fig. 2. Of course, other types and/or geometries of the heat exchanger 65 may be utilized depending on the required heat transfer characteristics. The outer part 62 may be thermally and mechanically connected to the heat exchanger 65 via a solder joint, e. g. using a silver solder.

In the example depicted in Fig. 2, the inner part 61 and the outer part 62 are configured as nested hollow cylinders. A section of the inner part 61 is arranged within a section of the outer part 62, and a section of the bung element 63 is arranged within a section of the inner part 61. The bung element 63 may comprise a cylindrical shape. According to an embodiment, the outer part 62, the inner part 61 and the bung element 63 are concentrically arranged along a common axis.

The thermal switch 60 may further comprise an intermediate part 64. The intermediate part 64 may be configured as a ring structure or a hollow cylinder arranged between the inner part 61 and the outer part 62. For example, the intermediate part 64 may be arranged within a groove provided in an outer surface of the inner part 61 as depicted in Fig. 2. The intermediate part 64 comprises a material with a higher thermal expansion coefficient than the material of the inner part 61. It is conceivable that the intermediate part 64 is made of a material used for the bung element 63 according to an embodiment described above. The intermediate part 64 may be configured to separate the inner part 61 from the outer part 62 at a temperature below the predefined temperature level. For example, as the temperature decreases, the material of the intermediate part 64 may contract more than the material of the inner part 61 and thus, separate the inner part 61 from the outer part 62. According to an embodiment, the intermediate part 64 is configured to maintain a contact between the inner part 61 and the bung element 63.

A thermal switch as depicted in Fig. 2 may be configured to enable and disable thermal conduction between the cold head 32 and the solid thermal conductor 39, depending on the temperature-dependent behaviour of the components within the thermal switch, e. g. the outer part 62, the inner part 61, and the bung element 63, but also the intermediate part 64. When the temperature of the bung element 63 exceeds a predefined temperature level, the bung element 63 may bring the inner part 61 into contact with the outer part 62 due to thermal expansion. As long as the outer part 62 remains in contact with the inner part 61, a thermal connection between the cold head 32 and the solid thermal conductor 39 may be provided, which allows for an exchange of thermal energy between the cold head 32 and the solid thermal conductor 39 via thermal conduction. When the temperature of the bung element 63 decreases below the predefined temperature level, a force acting on the inner part 61 due to thermal expansion of the bung element 63 may decrease or disappear, and the inner part 61 may separate from the outer part due to elastic restoring forces in the material of the inner part 61. A separation of the inner part 61 from the outer part 62 may be supported via provision of an intermediate part 64, which can be configured to contract and separate the inner part 61 from the outer part 62 when a temperature of the intermediate part is below the predefined temperature level. Once the inner part 61 mechanically separates from the outer part 62, the thermal connection between the cold head 32 and the solid thermal conductor 39 may be removed or eliminated.

Fig. 3 depicts a perspective view of an embodiment of an inner part 61 of a thermal switch 60 for a cryogenic system 30 according to the invention.

The inner part 61 may be configured as a ring-like structure or a hollow cylinder. In the depicted example, a wall or cylinder surface of the inner part 61 comprises multiple slots 66. The slots 66 extend along a surface of the inner part 61 in a longitudinal direction. It is conceivable that the slots 66 are configured in various arrangements to facilitate deformation of the inner part 61 in response to the thermal expansion and contraction of the bung element 63 (see Fig. 2).

According to an embodiment, the slots 66 provided in the wall of the inner part 61 are arranged helically instead of radially or longitudinally. The helical slots may extend along a surface of the inner part 61 in a spiral pattern. Helical slots may allow for a different deformation behaviour compared to radial slots.

In a further embodiment, the inner part 61 may comprise a combination of radial and longitudinal slots 66. The radial slots can extend from an outer surface towards a centre or an axis of the inner part 61, while the longitudinal slots can run parallel to the axis of the cylindrical or ring-like structure. A combination of radial and longitudinal slots may provide enhanced flexibility and controlled deformation of the inner part 61. It is also conceivable that the inner part 61 comprises one or more slots extending in a transverse direction of the inner part 61 without separating sections of the inner part 61.

An inner part 61 comprising slots 66 may favourably improve the thermal switch's response to temperature changes. For example, the slots 66 can allow the inner part 61 to expand or contract more readily, potentially improving the thermal switch's ability to enable and disable thermal conduction between the inner part 61 and the outer part 62 at specific temperature thresholds.

Fig. 4 shows a sectional view of an embodiment of a magnetic resonance device 10 comprising a cryogenic system 30 according to an embodiment of the invention. The magnetic resonance device 10 comprises an outer vacuum chamber 42 providing an outer enclosure for the components of the magnet arrangement 11. The outer vacuum chamber 42 separates a surrounding environment 70 from a vacuum region 71 encompassed by the outer vacuum chamber 42.

In the present example, the outer vacuum chamber 42 is configured as a double-walled hollow cylinder comprising an outer shell and an inner shell. The components of the magnet arrangement 11 are housed within the outer shell and the inner shell of the outer vacuum chamber 42. The inner shell of the outer vacuum chamber 42 forms a wall of the patient bore 37 encompassing the imaging region 36 in a circumferential direction.

In the illustrated embodiment, the magnet arrangement 11 comprises a thermal radiation shield 33. The thermal radiation shield 33 is configured as a double-walled hollow cylinder. The main magnet 12 is enclosed between an outer wall and an inner wall of the thermal radiation shield 33.

The magnet arrangement 11 may comprise a support structure configured to mechanically attach the main magnet 12 to the outer vacuum chamber 42. In the present example, the magnet arrangement 11 comprises one or more suspension elements 50 or suspension rods mechanically connected to the main magnet 12 and the outer shell of the outer vacuum chamber 42. The suspension elements 50 may extend through passages or holes in the thermal radiation shield 33 to provide a mechanical connection between the outer shell of the outer vacuum chamber 42 and the main magnet 12 or a magnet support structure configured to support the main magnet 12.

In the embodiment depicted in Fig. 4, the magnetic resonance device 10 comprises a first cryocooler 31a including a cold head 32a and second cryocooler 31b including a cold head 32b. The cold heads 32a and 32b are mounted on the outer shell of the outer vacuum chamber 42.

The first cryocooler 31a may be configured to cool the main magnet 12 and the thermal radiation shield 33, but also other components of the magnet arrangement 11, such as a cryogen vessel (not shown).

In the depicted example, the second cryocooler 31b comprises a single stage 32b.1. The single stage 32b.1 of the second cryocooler 31b is thermally connected to the thermal radiation shield 33 via the thermal switch 60 and a solid thermal conductor 39b.

The thermal switch 60 is configured to thermally connect the second cryocooler 31b and the thermal radiation shield 33 when a temperature of the bung element 63 exceeds a predefined temperature level. If the temperature of the bung element 63 (see Fig. 2) is below the predefined temperature level, the thermal switch 60 thermally separates the single stage 32b.1 from the thermal radiation shield 33. The predefined temperature level may substantially coincide with an operating temperature of the thermal radiation shield 33. However, the predefined temperature level may also be lower or higher than the operating temperature of the thermal radiation shield 33.

In some embodiments, the second cryocooler 31b may be thermally connected to further and/or other components of the magnet arrangement 11 via the thermal switch 60. Such further and/or components may comprise a shield tube, a further thermal radiation shield, but also the main magnet 12 and/or the support structure for the main magnet 12.

The cryocoolers 31a and 31b typically comprise one or more compressors (not shown) supplying pressurized gas or cryogen to the cold heads 32a and 32b. According to the embodiment shown in Fig. 4, the first cryocooler 31a includes a cold head 32a comprising a first stage 32a.1 and a second stage 32a.2. Preferably, the first stage 32a.1 of the cold head 32a is thermally connected to the thermal radiation shield 33, whereas the second stage 32a.2 of the cold head 32a is thermally connected to the main magnet 12.

According to an embodiment, the first cooling stage 32a.1 of the first cryocooler 31a is configured to provide a temperature level of about 43 K, whereas the second cooling stage 32a.2 of the first cryocooler 31a is configured to provide a temperature level of about 4.2 K. The first stage 32a.1 and the second stage 32a.2 of the first cryocooler 31a are thermally connected to the components of the magnet arrangement 11 via a thermal bus comprising solid thermal conductors 39a.1 and 39a.2. It is conceivable that the magnet arrangement 11 comprises one or more cryogen vessels (not shown) thermally connected to the first cryocooler 31a and/or the second cryocooler 31b via a thermal switch 60, e. g. using a similar thermal bus.

During operation of the magnetic resonance device 10, the thermal radiation shield 33 may be maintained at an intermediate temperature, e. g. a temperature in the range of 40 K to 60 K, preferably about 43 K. The thermal radiation shield 33 may comprise an electrically conductive material configured to shield the main magnet 12 from thermal radiation, but also from stray fields of the gradient magnetic fields generated via the gradient coils 18.

In some embodiments, the thermal radiation shield 33 and the main magnet 12 are thermally connected to the same cooling stage of the first cryocooler 31a.

In some embodiments, the thermal radiation shield 33 and/or the main magnet 12 are thermally connected to both cryocoolers 31a and 31b, wherein the cryocooler 31b is thermally connected to the thermal radiation shield 33 and/or the main magnet 12 via the thermal switch 60.

In the embodiment illustrated in Fig. 4, the single stage 32b.1 of the second cryocooler 31b is thermally connected to the thermal radiation shield 33 via the thermal switch 60 and the solid thermal conductor 39b. The solid thermal conductor 39b may be configured to bridge a gap between the thermal switch 60 and the thermal radiation shield 33. Particularly, the solid thermal conductor 39b may be thermally and mechanically connected to both the thermal switch 60 and the thermal radiation shield 33. It is conceivable that a further thermal bus element, e. g. a further solid thermal conductor 39, is thermally and mechanically connected to the thermal switch 60 and a further component of the magnet arrangement 11.

According to an embodiment, the inner part 61 of the thermal switch 60 is directly attached to a part to be cooled, e. g. a component of the magnet arrangement 11.

The thermal switch 60 may be configured to enable thermal conduction between the single stage 32b.1 of the second cryocooler 31b and the part to be cooled when a temperature of the bung element 63 exceeds a predefined temperature level, and to disable thermal conduction between the single stage 32b.1 of the second cryocooler 31b and the part to be cooled when the temperature of the bung element 63 is below the predefined temperature level.

According to an embodiment, the magnetic resonance device 10 is a "dry" MRI system. In a "dry" MRI system, the main magnet 12 may not be immersed in a bath of liquid cryogen. Rather, the cooling stages of the cryocoolers 31a and 31b may be connected to the components of the magnet arrangement 11 via solid thermal conductors 39. However, the magnet arrangement 11 of a "dry" MRI system may comprise one or more small cryogen vessels or thermal buffers (not shown) thermally connected to the cryocooler 31a and/or the cryocooler 31b via a solid thermal conductor 39 according to an embodiment described above.

Fig. 5 shows a schematic representation of an embodiment of a thermal switch 60 for a cryogenic system 30 according to the invention. The thermal switch 60 is constructed similarly to the embodiment of the thermal switch 60 depicted in Fig. 2. However, the thermal switch 60 depicted in Fig. 5 does not comprise an intermediate part 64.

When the temperature of the bung element 63 exceeds a predefined temperature level, the bung element 63 may bring the inner part 61 into contact with the outer part 62 due to thermal expansion. As long as the outer part 62 remains in contact with the inner part 61, a thermal connection between the cold head 32 and the solid thermal conductor 39 may be provided. The thermal connection may allow for a transport of thermal energy between the cold head 32 and the solid thermal conductor 39 via thermal conduction. When the temperature of the bung element 63 decreases below the predefined temperature level, a force acting on the inner part 61 due to thermal expansion of the bung element 63 may decrease or disappear, and the inner part 61 may separate from the outer part due to elastic restoring forces in the material of the inner part 61.

According to an embodiment, the thermal switch 60 may be configured to provide an adjustable activation temperature (or predefined temperature level). An adjustable activation temperature can be achieved by incorporating a mechanism to pre-stress the bung element 63. For example, an adjusting means, e. g. a threaded element, configured to compress or relax the bung element 63 can be included. A thermal switch 60 with an adjustable activation temperature may favourably allow for fine-tuning of the thermal switch's performance at different temperature levels without changing materials.

According to an example, the outer part 62 and the inner part 61 comprise the shapes of ring structures or hollow cylinders. The bung element 63 may comprise the shape of a cylinder. At 293 K, an outer diameter of the outer part 62 may be 101.60 mm, and an inner diameter of the outer part 62 may be 95.25 mm. The inner part 61 may exhibit an outer diameter of 95.05 mm and an inner diameter of 89.05 mm at 293 K. Thus, a radial gap between the inner part 61 and the outer part 62 may amount to 0.1 mm at the specified temperature level of 293 K.

At the same temperature, a bung element 63 made from PTFE may exhibit an outer diameter of 90.61 mm, resulting in a deformation of the inner part 61 and a deflection of the inner part 61 towards the outer part 62, if the bung element 63 is inserted or arranged within the inner part 61. If the bung element 63 is pre-cooled to about 77 K, it may exhibit an outer diameter of approximately 88.85 mm, allowing for an insertion or arrangement of the bung element 63 within the inner part 61 without deformation of the inner part 61.

The schematic representations provided in the figures do not represent any scale or size relationships.

The devices and systems described in detail above are merely exemplary embodiments which can be modified in a variety of ways by those skilled in the art without departing from the scope of the invention. Particularly, individual embodiments may be extended by or combined with features of other embodiments if not explicitly stated otherwise.

Furthermore, the use of the indefinite articles "a" or "an" does not preclude that individual features in question can also be present multiple times. Likewise, the terms "unit" and "element" do not preclude that the components in question consist of several interacting sub-components which can also be spatially distributed if necessary.

## Claims

1. A thermal switch (60) for a cryogenic system, comprising:
an inner part (61);
an outer part (62); and
a bung element (63);
wherein the bung element (63) comprises a material with a higher thermal expansion coefficient than a material of the inner part (61), and
wherein the bung element (63) is configured to bring the inner part (61) into contact with the outer part (62) when exceeding a predefined temperature level.

2. The thermal switch (60) according to claim 1, wherein at least a section of the bung element (63) is arranged within a cavity of the inner part (61).

3. The thermal switch (60) according to claim 1 or claim 2, wherein the bung element (63) is configured to deform at least a section of the inner part (61) when exceeding the predefined temperature level.

4. The thermal switch (60) according to claim 3, wherein the inner part (61) comprises a slot (66) configured to facilitate a deformation of the inner part (61) via the bung element (63).

5. The thermal switch (60) according to any of claims 1 to 4, further comprising an intermediate part (64) arranged between the inner part (61) and the outer part (62), wherein the intermediate part (64) comprises a material with a higher thermal expansion coefficient than the material of the inner part (61), and wherein the intermediate part (64) is configured to separate the inner part (61) from the outer part (62) at a temperature below the predefined temperature level.

6. The thermal switch (60) according to any preceding claim, wherein the predefined temperature level is at least 20 K, at least 30 K, at least 40 K, at least 50 K, at least 60 K, at least 70 K, at least 80 K, at least 90 K, or at least 100 K.

7. The thermal switch (60) according to any preceding claim, wherein the inner part (61) is thermally and mechanically connected to a solid thermal conductor (39).

8. The thermal switch (60) according to any preceding claim, wherein the inner part (61) and the outer part (62) comprise the shape of a ring, a hollow cylinder, or a hollow prism.

9. The thermal switch (60) according to any preceding claim, wherein the outer part (62) is thermally and mechanically connected to a cryocooler (31) or other cooling device.

10. The thermal switch (60) according to any preceding claim, wherein the bung element (63) comprises or consists of a plastic material, preferably polytetrafluoroethylene.

11. A cryogenic system (30), comprising:
a cryocooler (31);
a part to be cooled; and
the thermal switch (60) according to any of the claims 1 to 10,
wherein the outer part (62) is thermally and mechanically connected to the cryocooler (31),
wherein the inner part (61) is thermally and mechanically connected to the part to be cooled, and
wherein the thermal switch (60) is configured to enable thermal conduction between the part to be cooled and the cryocooler (31) when a temperature of the bung element (63) exceeds the predefined temperature level.

12. The cryogenic system (30) according to claim 11, wherein the part to be cooled comprises at least one of: a thermal radiation shield (33), a further thermal radiation shield, a superconducting magnet (12), a support structure for a superconducting magnet (12).

13. The cryogenic system (30) according to claim 11 or claim 12, wherein the cryocooler (31) comprises a single-stage cryocooler (31b).

14. The cryogenic system (30) according to any of claims 11 to 13, further comprising a solid thermal conductor (39) arranged between the thermal switch (60) and the part to be cooled.

15. A magnetic resonance device (10), configured to acquire magnetic resonance data from an object positioned in an imaging region (14) of the magnetic resonance device (10), comprising a magnet arrangement (11) including a superconducting magnet (12) and a cryogenic system (30) according to any of the claims 11 to 14, wherein the thermal switch (60) is configured to enable a thermal conduction between a component of the magnet arrangement (11) and the cryocooler (31) when a temperature of the bung element (63) exceeds the predefined temperature level.
